# EUROPÄISCHE PATENTANMELDUNG

(11) **EP 4 227 435 A2**
(43) Veröffentlichungstag der Anmeldung: **16.08.2023**
(21) Anmeldenummer: 23151231.0
(22) Anmeldetag: 12.01.2023
(51) Int. Cl.: C23F 13/04

(54) **VERFAHREN UND ELEKTRISCHE SCHALTUNGSANORDNUNGEN ZUM SCHUTZ VON METALLISCHEN BAUTEILEN GEGEN KORROSION DURCH STREUSTRÖME**

(30) Priorität: 18.01.2022 DE 102022101022
(71) Anmelder: Bender GmbH & Co. KG, 35305 Grünberg (DE)
(72) Erfinder: HACKL, Dieter, 35463 Fernwald (DE); SCHEPP, Karl, 35447 Reiskirchen (DE)
(74) Vertreter: advotec.

(57) **Zusammenfassung**

Die Erfindung betrifft Verfahren und elektrische Schaltungsanordnungen zum Schutz von metallischen Bauteilen (14) in einem elektrolytischen Medium (16) gegen Korrosion infolge eines Gleich-Streustroms (DC-Streustroms) (Is) aus einer Stromversorgungsanlage (4). In einer ersten Alternativlösung wird der DC-Streustrom als Gesamt-Summenstrom über alle aktiven Leiter zusammen mit dem Schutzleiter der Stromversorgungsanlage gemeinsam von einem DC-Gesamt-Differenzstromsensor (30) erfasst. In einer zweiten Alternativlösung wird ein kombinierter DC-Differenzstromsensor mittels einer Schaltvorrichtung umschaltbar ausgeführt, wobei ein Differenzstrom über alle aktiven Leiter der Stromversorgungsanlage erfasst wird oder der DC-Streustrom als Gesamt-Differenzstrom über alle aktiven Leiter und den Schutzleiter der Stromversorgungsanlage erfasst wird. In einer dritten Alternativlösung wird ein Differenzstrom über alle aktiven Leiter der Stromversorgungsanlage mittels eines Differenzstromwandlers (20) und ein Schutzleiterstrom mittels eines ausschließlich an dem Schutzleiter angeordneten separaten DC-Stromsensors erfasst und der DC-Streustrom wird durch Differenzbildung des von dem Differenzstromwandler erfassten Differenzstroms und des von dem separaten DC-Stromsensor erfassten Schutzleiterstroms rechnerisch ermittelt.

## Beschreibung

Die Erfindung betrifft Verfahren und elektrische Schaltungsanordnungen zum Schutz von metallischen Bauteilen in einem elektrolytischen Medium gegen Korrosion infolge eines Gleich-Streustroms (DC-Streustrom) aus einer Stromversorgungsanlage.

Ungeschützte metallische Bauteile, die sich in einer elektrolytischen Umgebung befinden, wie beispielsweise Stahleinlagen in einem Betonfundament oder erdverlegte metallische Vorrichtungen, sind der Korrosion durch DC-Streuströme aus Stromversorgungsanlagen ausgesetzt. Bei Bauwerken aus Stahlbeton kann der an dem Bewehrungsstahl auftretende Materialabtrag zu einer Schwächung der Statik führen oder bei erdverlegten Rohrleitungen Undichtigkeiten verursachen.

Negative, teils sogar gefährlich schwächende Einflüsse auf die Statik von Bauwerken entstehen dabei nicht erst durch DC-Streuströme im Amperebereich, sondern bereits bei DC-Streuströmen im Milli-AmpereBereich, wenn diese DC-Streuströme kontinuierlich und meist unbemerkt über einen längeren Zeitraum fließen.

Ein geeignetes Mittel zur Vermeidung von DC-Streuströmen direkt an der Stromversorgungsquelle einer Stromversorgungsanlage besteht in der Installation eines Stromversorgungssystems mit einer ungeerdeten Netzform (IT-System - frz. Isolé Terre) und der Sicherstellung eines sehr hochohmigen Isolationswiderstandsniveaus gegen Erde mit Überwachung des Isolationszustandes durch ein normgerechtes Isolationsüberwachungsgerät (IMD - Insulation Monitoring Device).

Bei Anwendungen, wo dies nicht möglich ist und eine geerdete Netzform zum Einsatz kommt, werden in der Norm DIN EN 50162 Anforderungen an die Berücksichtigung und Vermeidung von Korrosion durch DC-Streuströme gestellt und verschiedene Maßnahmen empfohlen - beispielsweise der Einsatz von Korrosionsschutzeinrichtungen, von korrosionsresistenten Materialien oder die Anwendung von Beschichtungsverfahren zur Isolierung eines metallischen Leiters gegenüber der elektrolytischen Umgebung.

Die Norm DIN EN 50162 nimmt dabei Bezug auf bekannte Anwendungen, bei denen bereits negative Erfahrungen mit Korrosionseffekten durch DC-Streuströme gemacht wurden, beispielsweise im Bahnbereich oder in der Galvanikindustrie.

Nicht berücksichtigt und zu wenig beachtet wird die zunehmende Verbreitendung von DC-Stromversorgungssystemen vor allem im industriellen Bereich und im Bereich der Ladestationen-Infrastruktur für Elektrofahrzeuge (EV-Ladestationen).

Es ergibt sich die Fragestellung, welcher Einfluss, über einen langen Zeitraum betrachtet, der stark zunehmenden Anzahl von Elektrofahrzeugen zukommt, die beispielsweise in einem Parkhaus an eine Ladestation angeschlossen sind und diese Ladestation durch Alterung und Verschmutzungseffekte bis zu 1mA große DC-Streuströme über das Stahlbetonfundament des Parkhauses ableitet. Dabei werden hier nicht diejenigen DC-Fehlerstromkreise oder DC-Ableitstromkreise betrachtet, die über den angeschlossenen Schutzleiter führen, sondern elektrisch leitfähige Strompfade in der elektrolytischen Bauwerkstruktur. Ähnliche Szenarien mit negativen Auswirkungen auf die Bauwerkstatik sind bei dem vermehrten Einsatz von DC-gespeisten Maschinen, wie etwa Fertigungsrobotern, zu bedenken.

Bisher wurde das Problem der Korrosion von metallischen Bauteilen in einem elektrolytischen Medium durch DC-Streuströme nur mit Bezug auf Anwendungen betrachtet, bei denen bereits negative Erfahrungen mit Korrosionseffekten durch DC-Streuströme vorliegen. So kommen im Bahnbereich oder in der Galvanikindustrie die Empfehlungen der DIN EN 50162 zum Einsatz.

Für potentiell korrosionsgefährdete Einrichtungen ist bislang nur unzureichend untersucht worden, ob und in welcher Stärke DC-Streuströme aus Stromversorgungsanlagen in ein umgebendes elektrolytisches Medium übergehen und dort an dem metallischen Bauteil Korrosionseffekte hervorrufen. Um in einem bestimmten Anwendungsfall geeignete Korrosionsschutzmaßnahmen ergreifen zu können, ist die messtechnische Überwachung und Beurteilung von DC-Streuströmen in kritischen Einrichtungen unabdingbar.

Zu den hier betrachteten kritischen Einrichtungen zählen beispielsweise jene, bei denen innovative elektrische Betriebsmittel in großen Stückzahlen zukünftig in Verkehr gebracht werden (Beispiel: DC-gespeiste Maschinen, speziell Roboter, in industriellen Anlagen) oder bei denen zu vermuten ist, dass nach einer Degradation von Isolierstrecken DC-Streuströme dauerhaft und so wirksam in die Gebäudeinfrastruktur abfließen, dass die Gefahr einer Schwächung der Bauwerkstatik besteht (Beispiel: EV-Ladestationen in Parkhäusern).

Der vorliegenden Erfindung liegt somit die Aufgabe zu Grunde, ein Verfahren und eine Vorrichtung zum Schutz von metallischen Bauteilen in einer elektrolytischen Umgebung gegen Korrosion durch einen DC-Streustrom zu entwerfen.

Diese Aufgabe wird in einer ersten Alternativlösung dadurch gelöst, dass der DC-Streustrom als Gesamt-Summenstrom über alle aktiven Leiter zusammen mit dem Schutzleiter der Stromversorgungsanlage gemeinsam von einem DC-Gesamt-Differenzstromsensor erfasst wird.

Der Grundgedanke der vorliegenden Erfindung besteht darin, bei korrosionsgefährdeten Einrichtungen an der stromversorgenden Anlage eine möglichst hochsensitive DC-Differenzstromüberwachung zu installieren, die in der Lage ist, einen DC-Streustrom von auftretenden Fehlerströmen und unvermeidlich vorhandenen Ableitströmen unterscheiden und bewerten zu können.

Messtechnisch ist daher der Unterschied maßgeblich zwischen den in den Einrichtungen bereits vorhandenen Differenzstromwandlern (einer Fehlerstrom-Schutzeinrichtung (RCD) oder Differenzstromüberwachungseinrichtung (RCM)) zur Erkennung von über den Schutzleiter fließenden Fehler-/Ableitströmen einerseits und den erfindungsgemäß installierten DC-Differenzstromsensoren zur Erkennung der über das umgebende elektrolytische Medium abfließenden DC-Streuströme andererseits.

Selbst wenn zur Sicherstellung der Funktion einer Typ A (RCD) Fehlerstrom-Schutzeinrichtung bereits ein Differenzstromwandler als DC-Messstromwandler zur Erkennung von Gleich-Fehlerströmen ausgeführt ist und damit ein 5mA-DC-Differenzstrom messtechnisch festgestellt werden kann, bedeutet dies nicht, dass dieser erfasste 5mA-DC-Differenzstrom auch ein 5mA-DC-Streustrom ist, der zu Korrosionserscheinungen führt. Fließt dieser 5mA-DC-Differenzstrom nämlich ausschließlich durch einen isolierten Schutzleiter in den zentralen Erdungspunkt der Stromversorgungsanlage und nicht über die elektrolytische Umgebung, so sind hier keinerlei Korrosionseffekte zu erwarten.

Die bisher zum Einsatz kommende Differenzstrommesstechnik kann nicht zwischen DC-Fehler-/Ableitströmen in das isoliert aufgebaute Schutzleitersystem und DC-Streuströmen in ein elektrolytisches Medium unterscheiden, da mittels des gemäß dem Stand der Technik installierten Differenzstromwandlers alle Stromanteile als Differenzstrom erfasst werden, die nicht über die aktiven Leiter fließen, somit neben den DC-Fehler-/Ableitströmen über den Schutzleiter auch die über die elektrolytische Umgebung abfließenden DC-Streuströme.

Die vorgenannten Überlegungen gelten gleichermaßen für die zweite und dritte Alternativlösung.

In der ersten Alternativlösung kommt erfindungsgemäß - meistens neben einem als Fehlerschutzmaßnahme bereits installierten Differenzstromwandler - ein zusätzlicher DC-Gesamt-Differenzstromsensor zum Einsatz, bei dem nicht, wie aus dem Stand der Technik bekannt und entgegen üblicher Installationsanweisungen, eine Differenzstrommessung ausschließlich über die aktiven Leiter erfolgt, sondern gemeinsam über alle aktiven Leiter und den Schutzleiter.

Der DC-Gesamt-Differenzstromsensor erfasst somit als Gesamt-Differenzstrom nur den DC-Streustrom, der in das elektrolytische Medium abfließt und geeignet ist Korrosionen in metallischen Bauteilen, beispielsweise der Bauwerkstruktur, zu verursachen.

Der Dynamikumfang des DC-Gesamt-Differenzstromsensors muss nicht auf die sehr viel größer zu erwartenden DC-Fehler- und Ableitströme ausgelegt werden und kann daher die sehr klein zu erwartenden DC-Streuströme hoch auflösen.

Insbesondere wird der DC-Streustrom hochsensitiv mit einer Auflösung von kleiner als 1mA erfasst.

Der DC-Gesamt-Differenzstromsensor kann einen zugunsten einer hohen Auflösung beschränkten Messbereich (Dynamikumfang) aufweisen, da sich durch die Einbeziehung des Schutzleiters in den Gesamt-Differenzstrom die gegenüber dem DC-Streustrom vielfach größeren Fehler-/Ableitströme kompensieren. Der verbleibende Gesamt-Differenzstrom entspricht dem zu detektierenden DC-Streustrom, an den der gemeinsame DC-Gesamt-Differenzstromsensor hinsichtlich des Messbereichs und der Auflösung angepasst werden kann. Somit ist es möglich, auch kleine DC-Streuströme mit einer Größe unterhalb von 1mA zu erkennen.

In der zweiten Alternativlösung wird die Aufgabe dadurch gelöst, dass ein kombinierter DC-Differenzstromsensor mittels einer Schaltvorrichtung umschaltbar ausgeführt ist, wobei in einer ersten Schalterstellung ein Differenzstrom über alle aktiven Leiter der Stromversorgungsanlage erfasst wird und in einer zweiten Schalterstellung der DC-Streustrom als Gesamt-Differenzstrom über alle aktiven Leiter und den Schutzleiter der Stromversorgungsanlage erfasst wird.

In dieser zweiten Alternativlösung wird in vorteilhafterweise nur ein einziger, nämlich ein kombinierter DC-Differenzstromsensor benötigt, der entsprechend der Schalterstellung der Schaltvorrichtung entweder in Funktion eines üblichen nach dem Stand der Technik eingesetzten Differenzstromwandlers arbeitet und (nur) die aktiven Leiter der Stromversorgungsanlage umfasst (erste Schalterstellung) oder - wie in der ersten Alternativlösung in Funktion als DC-Gesamt-Differenzstromsensor - den Gesamt-Differenzstrom über alle aktiven Leiter und (auch) den Schutzleiter der Stromversorgungsanlage erfasst (zweite Schalterstellung).

Der Dynamikumfang des kombinierten DC-Differenzstromsensors muss jedoch im Gegensatz zu dem in der ersten Alternativlösung beschriebenen DC-Gesamt-Differenzstromsensors auch auf die sehr viel größer zu erwartenden DC-Fehler- und Ableitströme ausgelegt werden und kann daher die sehr klein zu erwartenden DC-Streuströme nur mit geringerer Auflösung erkennen.

In der dritten Alternativlösung wird die Aufgabe dadurch gelöst, dass ein Erfassen eines Differenzstroms über alle aktiven Leiter der Stromversorgungsanlage mittels eines Differenzstromwandlers erfolgt, ein Schutzleiterstrom mittels eines ausschließlich an dem Schutzleiter angeordneten separaten DC-Stromsensors erfasst wird und der DC-Streustrom durch Differenzbildung des von dem Differenzstromwandler erfassten Differenzstroms und des von dem separaten DC-Stromsensor erfassten Schutzleiterstroms rechnerisch ermittelt wird.

In dieser dritten Alternativlösung wird ein gemäß dem Stand der Technik zur Fehlerstromerkennung installierter Differenzstromwandler vorausgesetzt. Dieser Differenzstromwandler erfasst als Differenzstrom sämtliche Ströme, deren Stromkreise sich nicht ausschließlich über die aktiven Leiter der Stromversorgungsanlage schließen, somit neben dem DC-Fehler-/Ableitstrom auch den DC-Streustrom.

Der zusätzlich installierte separate DC-Stromsensor hingegen erfasst als Absolutstrom (Schutzleiterstrom) nur den über den Schutzleiter fließenden DC-Fehler-/Ableitstrom.

Durch Differenzbildung des von dem Differenzstromwandler erfassten Differenzstroms und des von dem DC-Stromsensor erfassten Schutzleiterstrom lässt sich der DC-Streustrom in einer Recheneinheit bestimmen.

Auch hier muss der Dynamikumfang des Differenzstromwandlers und der des separaten DC-Stromsensors für die sehr viel größer zu erwartenden Fehler- und Ableitströme ausgelegt werden, was gegenüber sich gegenüber der ersten Alternativlösung nachteilig bemerkbar macht.

In weiterer Ausgestaltung erfolgt ein Erkennen einer Überschreitung eines einstellbaren DC-Streustrom-Grenzwertes durch den DC-Streustrom und ein Signalisieren der Überschreitung.

Wird in einer Recheneinheit eine Überschreitung eines DC-Streustrom-Grenzwertes festgestellt, so erfolgt mittels einer Signalisierungseinrichtung, beispielsweise durch eine Alarmmeldung vor Ort oder über, per Schnittstelle verteilte, Alarmmitteilungen, eine Signalisierung, dass ein korrosionsgefährdender DC-Streustrom erkannt wurde.

Der DC-Streustrom-Grenzwert ist dabei an die überwachte kritische Einrichtung, insbesondere an die Leitfähigkeit des elektrolytischen Mediums und die Streustrom-Korrosionsempfindlichkeit des verlegten metallischen Bauteils durch Einstellung anpassbar.

Die jeweiligen Verfahrensschritte der drei Alternativlösungen werden mit entsprechenden strukturellen Merkmale in drei erfindungsgemäßen elektrischen Schaltungsanordnungen umgesetzt.

Somit treffen die mit den beanspruchten Verfahren erzielten technischen Wirkungen und die daraus resultierenden Vorteile gleichermaßen auch auf die elektrischen Schaltungsanordnungen zu.

Die beanspruchten elektrischen Schaltungsanordnungen stellen damit ebenso drei zu den beanspruchten Verfahren jeweils korrespondierende Alternativlösungen dar, die sich untereinander und insbesondere von dem Stand der Technik in der Anordnung und Ausführung der Differenzstrom-Messtechnik unterscheiden.

Dabei zeichnet sich die erste Alternativlösung durch einen DC-Gesamt-Differenzstromsensor aus, die zweite Alternativlösung durch einen umschaltbaren kombinierten DC-Differenzstromsensor mit Schaltvorrichtung und die dritte Alternativlösung durch einen separaten DC-Stromsensor im Zusammenwirken mit einer Differenzbildung in einer Recheneinheit.

Um den Unterschied zwischen einem DC-Fehler-/Ableitstrom und einem korrosionswirksamen DC-Streustrom zu erkennen, wird die erfindungsgemäße Verschaltung der DC-Stromsensorik abweichend von und entgegen der im Stand der Technik vorgeschriebenen Weise vorgenommen. Insbesondere die Einbeziehung des Schutzleiters in die Erfassung durch einen Differenzstromwandler würde dem Stand der Technik gemäß sogar als fehlerhaft bezeichnet werden.

Weitere vorteilhafte Ausgestaltungsmerkmale ergeben sich aus der nachfolgenden Beschreibung und den Zeichnungen, die bevorzugte Ausführungsformen der Erfindung an Hand von Beispielen erläutern. Es zeigen:
- **Fig. 1:**: eine Differenzstrommessung zur Bestimmung eines Fehlerstroms nach dem Stand der Technik,
- **Fig. 2:**: eine erfindungsgemäße DC-Gesamt-Differenzstrommessung,
- **Fig. 3:**: eine erfindungsgemäße kombinierte DC-Differenzstrommessung und
- **Fig. 4:**: eine erfindungsgemäße separate DC-Strommessung.

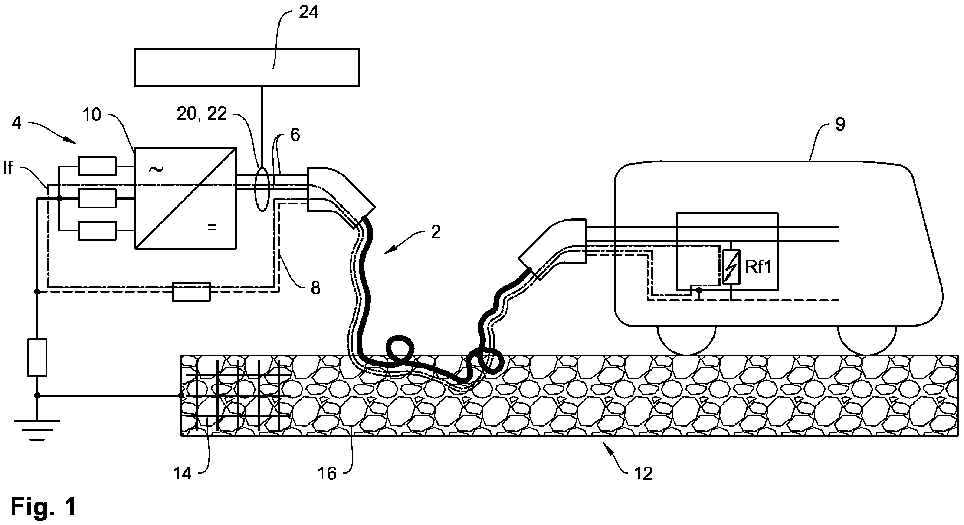

**Fig. 1** zeigt eine Differenzstrommessung nach dem Stand der Technik zur Bestimmung eines DC-Fehler-/Ableitstroms If an dem Beispiel einer als kritische Einrichtung 2 erachteten Stromversorgungsanlage 4 mit Ladestation 10. Die Stromversorgungsanlage 4 ist gleichstromseitig über zwei aktive Leiter 6 und den Schutzleiter 8 mit einem Elektrofahrzeug 9 verbunden.

Zur Überwachung und Bestimmung des DC-Fehler-/Ableitstroms If ist ein Differenzstromwandler 20 vorgesehen, durch den vorschriftgemäß (nur) die aktiven Leiter 6 geführt werden, wohingegen der Schutzleiter 8 außen an dem Differenzstromwandler 20 vorbeigeführt wird.

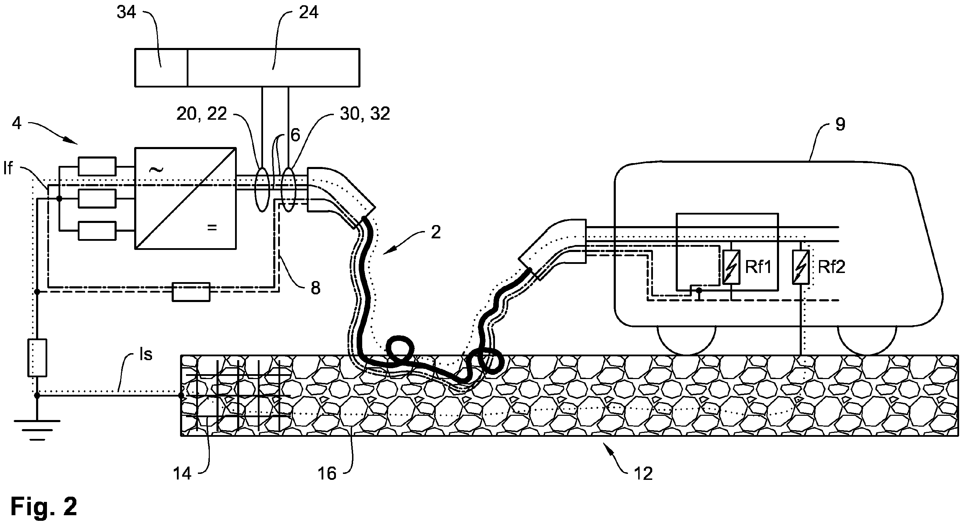

Erfasst wird - ein DC-Streustrom **(****Fig. 2****)** sei in **Fig. 1** nicht betrachtet - somit der DC-Fehler-/Ableitstrom If, der in dem Elektrofahrzeug über einen Isolationsfehler Rf1 gegen leitfähige, mit dem Schutzleiter 8 verbundene Teile (Körperschluss) fließt.

In **Fig. 2** ist in einer ersten Alternativlösung eine erfindungsgemäße DC-Gesamt-Differenzstrommessung im Fall eines möglichen DC-Streustroms Is dargestellt, welcher in dem Elektrofahrzeug, verursacht durch einen Isolationsfehler Rf2, über ein elektrolytisches Medium 16 (Stahlbeton) eines Bauwerks 12 (Parkhaus) abfließt.

Zusätzlich zu dem vorschriftsgemäß als Fehlerschutzmaßnahme installierten Differenzstromwandler 20 ist erfindungsgemäß ein vorzugsweise als Ringkernwandler ausgeführter DC-Gesamt-Differenzstromsensor 30 so angeschlossen, dass als Gesamt-Differenzstrom 32 die Ströme aller aktiven Leiter 6 und der in dem Schutzleiter 8 fließende Strom gemeinsam erfasst werden.

Weil mit dem DC-Gesamt-Differenzstromsensor 30 neben den aktiven Leitern 6 auch der Schutzleiter 8 mitgemessen wird, hebt sich der DC-Fehler-/Ableitstrom If auf, sodass als Gesamt-Differenzstrom 32 nur der DC-Streustrom Is verbleibt und in einer Recheneinheit 24 hinsichtlich der Überschreitung eines einstellbaren DC-Streustrom-Grenzwertes bewertet werden kann.

Erfasst wird also nur der korrosionswirksame, durch Rf2 bewirkte Streustrom Is, der in dem Elektrofahrzeug 9 an elektrisch leitfähigen, mit dem Schutzleiter 8 verbundene Teilen vorbei direkt über das elektrolytische Stahlbetonfundament 16 des Parkhauses 12 fließt.

In dem zur Fehlerstrommessung vorschriftsmäßig angeschlossenen Differenzstromwandler 20 hingegen wird auch der über den elektrolytischen Stahlbeton 16 des Parkhauses 12 fließende DC-Streustrom Is neben dem DC-Fehler-/Ableitstrom If miterfasst, ist aber nicht von dem DC-Fehler-/Ableitstrom If unterscheidbar und nicht messtechnisch auflösbar, da der DC-Streustrom Is in der hier beschriebenen Ladestromanwendung um mindestens einen Faktor 10 geringer anzunehmen ist als der DC-Fehler-/Ableitstrom If.

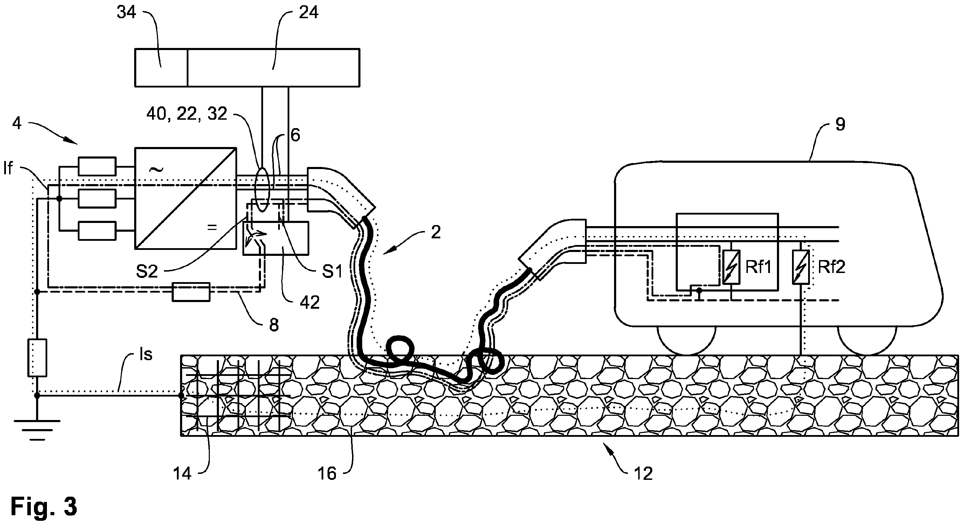

**Fig. 3** zeigt in einer zweiten Alternativlösung eine erfindungsgemäße kombinierte DC-Differenzstrommessung mit einem, vorzugsweise als Ringkernwandler ausgeführten, kombinierten DC-Differenzstromsensor 40, der mittels einer Schaltvorrichtung 42 umschaltbar ausgeführt ist.

In Abhängigkeit der Schalterstellungen S1, S2 werden entweder nur die aktiven Leiter 6 (Schalterstellung S1) oder die aktiven Leiter 6 und der Schutzleiter 8 (Schalterstellung S2) durch den kombiniertem DC-Differenzstromsensor 40 geführt.

In Schalterstellung S1 ist der kombinierte DC-Differenzstromsensor 40 als Differenzstromwandler 20 **(****Fig. 1****)** wirksam, der als Differenzstrom 22 die Summe aller durch die Isolationsfehler Rf1 und Rf2 bewirkten Ströme erfasst.

In Schalterstellung S2 wird in Funktion des DC-Gesamt-Differenzstromsensors 30 **(****Fig. 2****)** nur der DC-Streustrom Is als Gesamt-Differenzstrom 32 erfasst.

Da die Schaltvorrichtung 42 den Schutzleiter 8 schaltet, kann sich diese Lösung als normativ kritisch erweisen. Die Schaltvorrichtung 42 muss den Schutzleiter 8 unterbrechungsfrei umschalten, wobei die Anforderungen an die Niederohmigkeit der Schutzleiter-Schleifenimpedanz zu keiner Zeit überschritten werden dürfen und die Abschaltzeit einer Überstromschutzeinrichtungen darf durch die Eigenschaften der Schaltervorrichtung 42 nicht negativ beeinflusst werden.

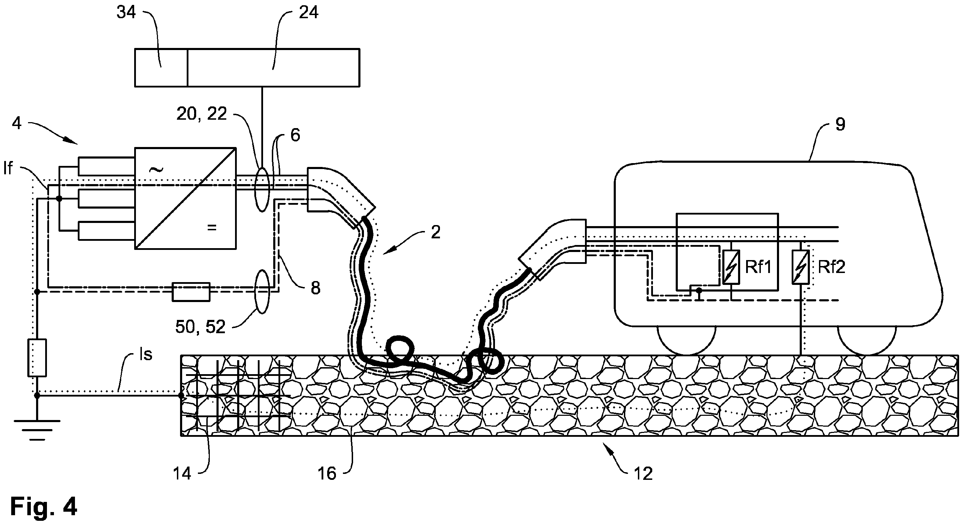

**Fig. 4** zeigt in einer dritten Alternativlösung eine erfindungsgemäße separate DC-Strommessung mit einem, vorzugsweise als Ringkernwandler ausgeführten, separaten DC-Stromsensor 50.

Der DC-Stromsensor 50 umschließt ausschließlich den Schutzleiter 8 und erfasst somit den durch den Isolationsfehler Rf1 bewirkten Schutzleiterstrom 52, der dem DC-Fehler-/Ableitstrom If entspricht.

Der Differenzstromwandler 20 erfasst - in vorschriftsmäßig nur über die aktiven Leiter 6 installierter Weise - den Differenzstrom 20, der der Summe aller durch die Isolationsfehler Rf1 und Rf2 bewirkten Ströme, also dem DC-Fehler-/Ableitstrom If und dem DC-Streustrom Is entspricht.

Durch Differenzbildung des Differenzstroms 20 und des Schutzleiterstroms 52 wird der korrosionswirksame DC-Streustrom Is in der Recheneinheit 24 rechnerisch ermittelt.

Eine Überschreitung eines einstellbaren DC-Streustrom-Grenzwertes durch den DC-Streustrom Is wird in der Recheneinheit 24 erkannt und durch eine Signalisierungseinrichtung 34 signalisiert.

## Patentansprüche

1. Verfahren zum Schutz von metallischen Bauteilen (14) in einem elektrolytischen Medium (16) gegen Korrosion infolge eines DC-Streustroms (Is) aus einer Stromversorgungsanlage (4),
**dadurch gekennzeichnet,**
**dass** der DC-Streustrom (Is) als Gesamt-Differenzstrom (32) über alle aktiven Leiter (6) zusammen mit dem Schutzleiter (8) der Stromversorgungsanlage gemeinsam von einem DC-Gesamt-Differenzstromsensor (30) erfasst wird.

2. Verfahren nach Anspruch 1,
**dadurch gekennzeichnet,**
**dass** der DC-Streustrom (Is) hochsensitiv mit einer Auflösung von kleiner als 1mA erfasst wird.

3. Verfahren zum Schutz von metallischen Bauteilen (14) in einem elektrolytischen Medium (16) gegen Korrosion infolge eines DC-Streustroms (Is) aus einer Stromversorgungsanlage (4),
**dadurch gekennzeichnet,**
**dass** ein kombinierter DC-Differenzstromsensor (40) mittels einer Schaltvorrichtung (42) umschaltbar ausgeführt ist, wobei in einer ersten Schalterstellung (S1) ein Differenzstrom über alle aktiven Leiter (6) der Stromversorgungsanlage (4) erfasst wird und in einer zweiten Schalterstellung (S2) der DC-Streustrom (Is) als Gesamt-Differenzstrom über alle aktiven Leiter (6) und den Schutzleiter (8) der Stromversorgungsanlage (4) erfasst wird.

4. Verfahren zum Schutz von metallischen Bauteilen (14) in einem elektrolytischen Medium (16) gegen Korrosion infolge eines DC-Streustroms (Is) aus einer Stromversorgungsanlage (4), umfassend die Verfahrensschritte:
Erfassen eines Differenzstroms über alle aktiven Leiter (6) der Stromversorgungsanlage (4) mittels eines Differenzstromwandlers (20),
**dadurch gekennzeichnet,**
**dass** ein Schutzleiterstrom (52) mittels eines ausschließlich an dem Schutzleiter (8) angeordneten separaten DC-Stromsensors (50) erfasst wird und
der DC-Streustrom (Is) durch Differenzbildung des von dem Differenzstromwandler (20) erfassten Differenzstroms und des von dem separaten DC-Stromsensor (50) erfassten Schutzleiterstroms (52) rechnerisch ermittelt wird.

5. Verfahren nach einem der Ansprüche 1 bis 4,
**gekennzeichnet durch**
Erkennen einer Überschreitung eines einstellbaren DC-Streustrom-Grenzwertes **durch** den DC-Streustrom (Is) und Signalisieren der Überschreitung.

6. Elektrische Schaltungsanordnung zum Schutz von metallischen Bauteilen (14) in einem elektrolytischen Medium (16) gegen Korrosion infolge eines DC-Streustroms (Is) aus einer Stromversorgungsanlage (4),
**gekennzeichnet durch**
einen DC-Gesamt-Differenzstromsensor (30), der den DC-Streustrom (Is) als Gesamt-Differenzstrom (32) über alle aktiven Leiter (6) zusammen mit dem Schutzleiter (8) der Stromversorgungsanlage (4) gemeinsam erfasst.

7. Elektrische Schaltungsanordnung nach Anspruch 6,
**dadurch gekennzeichnet,**
**dass** der DC-Gesamt-Differenzstromsensor (30) hochsensitiv für eine Auflösung von kleiner als 1mA ausgelegt ist.

8. Elektrische Schaltungsanordnung zum Schutz von metallischen Bauteilen (14) in einem elektrolytischen Medium (16) gegen Korrosion infolge eines DC-Streustroms (Is) aus einer Stromversorgungsanlage (4),
**gekennzeichnet durch**
einen kombinierten DC-Differenzstromsensor (40), der mittels einer Schaltvorrichtung (42) umschaltbar ausgeführt ist, wobei der kombinierte DC-Differenzstromsensor (40) in einer ersten Schalterstellung (S1) einen Differenzstrom über alle aktiven Leiter (6) der Stromversorgungsanlage (4) erfasst und in einer zweiten Schalterstellung (S2) der DC-Streustrom (Is) als Gesamt-Differenzstrom über alle aktiven Leiter (6) und den Schutzleiter (8) der Stromversorgungsanlage (4) erfasst wird.

9. Elektrische Schaltungsanordnung zum Schutz von metallischen Bauteilen (14) in einem elektrolytischen Medium (16) gegen Korrosion infolge eines DC-Streustroms (Is) aus einer Stromversorgungsanlage (4),
mit einem Differenzstromwandler (20), der einen Differenzstrom über alle aktiven Leiter (6) der Stromversorgungsanlage (4) erfasst, **gekennzeichnet durch**
einen separaten DC-Stromsensor (50), der ausschließlich an dem Schutzleiter (8) angeordnet ist und einen Schutzleiterstrom (52) erfasst, und
mit einer Recheneinheit (24), die konfiguriert ist, den DC-Streustrom (Is) **durch** Differenzbildung des von dem Differenzstromwandler (20) erfassten Differenzstroms und des von dem separaten DC-Stromsensor (50) erfassten Schutzleiterstroms (52) rechnerisch zu ermitteln.

10. Elektrische Schaltungsanordnung nach einem der Ansprüche 6 bis 9, **gekennzeichnet durch**
eine Recheneinheit (24), die konfiguriert ist zur Erkennung einer Überschreitung eines einstellbaren Streustrom-Grenzwertes **durch** den DC-Streustrom (Is) und eine Signalisierungseinrichtung (34), welche die Überschreitung signalisiert.
